(19) Europäisches Patentamt
European Patent Office
Office européen des brevets

(11) Veröffentlichungsnummer: **0 355 652 A2**

(12) # EUROPÄISCHE PATENTANMELDUNG

(21) Anmeldenummer: **89115002.1**

(22) Anmeldetag: **14.08.89**

(51) Int. Cl.4: **C08F 12/22 , C09J 125/18 , B01J 20/26 , G03F 7/038**

(30) Priorität: **18.08.88 DE 3828064**

(43) Veröffentlichungstag der Anmeldung: **28.02.90 Patentblatt 90/09**

(84) Benannte Vertragsstaaten: **BE DE FR GB IT NL**

(71) Anmelder: **HOECHST AKTIENGESELLSCHAFT**
**Postfach 80 03 20**
**D-6230 Frankfurt am Main 80(DE)**

(72) Erfinder: **Fuss, Andreas, Dr.**
**Lindigstrasse 24**
**D-8757 Karlstein(DE)**
Erfinder: **Hintzer, Klaus, Dr.**
**Rupertusstrasse 3**
**D-8269 Burgkirchen(DE)**

(54) **Polymerisate aus substituierten (2-Haloalkoxy-1,1,2-trifluoräthoxy)-styrolen, Verfahren zu ihrer Herstellung und ihre Verwendung.**

(57) Homo- und Copolymerisate auf Basis von (2-Halo-alkoxy-1,1,2-trifluoräthoxy)-styrolen der allgemeinen Formel

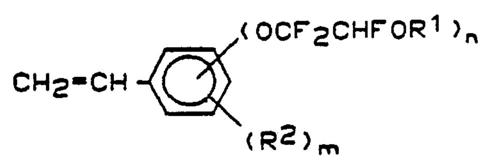

(I) ,

Verfahren zu ihrer Herstellung durch radikalische Polymerisation in Gegenwart von Radikalbildnern sowie die Verwendung der Polymerisate als Trägermaterial und Trennungsphase für chromatograhpische Verfahren, als Material für optische Systeme, als Resists, als Formteile und Klebstoffe.

EP 0 355 652 A2

## Polymerisate aus substituierten (2-Haloalkoxy-1,1,2-trifluoräthoxy)-styrolen, Verfahren zu ihrer Herstellung und ihre Verwendung

Die Erfindung betrifft Homo- und Copolymerisate aus (2-Haloalkoxy-1,1,2-trifluoräthoxy)-styrolen, Verfahren zu ihrer Herstellung und ihre Verwendung.

Herkömmliche organische Trägermaterialien aus Styrol und Divinylbenzol sind für die analytische Charakterisierung von Fluorpolymeren in halogenhaltigen Lösungsmitteln durch Gelpermeationschromatographie völlig ungeeignet, da das Trägermaterial nicht vom Lösungsmittel gequollen bzw. benetzt wird; es erfolgt, infolge der großen Unverträglichkeit zwischen der Trennphase und der Polymerlösung, teilweise eine Ausfällung des Polymeren auf der Trennphase, wodurch ein völlig irreguläres Elutionsverhalten resultiert. Solche halogenhaltige Lösungsmittel sind beschrieben (EP-A 0 260 587 bzw. DE-A 37 44 392).

Fluorhaltige Polystyrole sind beschrieben in EP-B 0 025 159, GB-A 2 080 559 und JP 62 158 234 (= Derwent Report 87-232801/33). Einige der beschriebenen Polystyrole scheiden für den Einsatz in der Chromatographie aus, da sie säure- bzw. basenlabile Gruppierungen enthalten (GB-A 2 080 559).
Die beiden anderen Veröffentlichungen beschreiben stabile fluorhaltige Styrolpolymere, jedoch ist weder ein Hinweis auf ihren Einsatz in der Gelpermeationschromatographie noch auf ihr Verhalten in den angeführten Lösungsmittel gegeben.

Durch die Einführung von Fluorsubstituenten in die Trägerphase lassen sich die Materialien mit den Lösungsmitteln verträglicher machen.

Es wurden nun Polymerisate gefunden, die als Trägermaterialien für die Gelpermeationschromatographie verwendet werden können, da sie sowohl in fluorfreien Lösungsmitteln (z.B. Tetrahydrofuran) als auch in halogenierten Lösungsmitteln gut quellen und somit für das obengenannte Chromatographieverfahren eingesetzt werden können.

Gegenstand der vorliegenden Erfindung sind Homo- und Copolymerisate, die auf Basis von (2-Haloalkoxy-1,1,2-trifluoräthoxy)-styrolen der allgemeinen Formel (I) aufgebaut sind

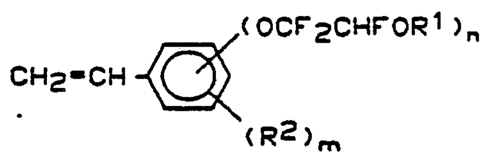

(I)

worin
$R^1$ teilweise oder vollständig halogeniertes $C_1$-$C_{10}$-Alkyl-, vorzugsweise eine $C_1$-$C_3$-Alkylgruppe oder einen Rest der Formel (II) oder (III)

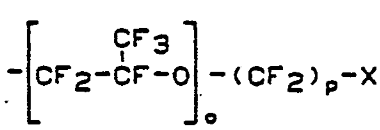

(II)

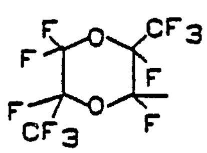

(III)

und $R^2$, Wasserstoff, Halogen oder eine teilweise oder vollständig halogenierte $C_1$-$C_8$-Alkylgruppe, vorzugsweise $C_1$-$C_3$-Alkyl, wobei die Alkylgruppen $R^1$ und $R^2$ gleich oder verschieden sind,
m ist als ganze Zahl 1, 2, 3 oder 4,
n ist als ganze Zahl 1, 2 oder 3,
o ist als ganze Zahl 1, 2, 3 oder 4,
p ist als ganze Zahl 1, 2, 3, 4, 5, 6, 7, 8, 9 oder 10 und
X Halogen oder Wasserstoff bedeuten, mit der Maßgabe, daß die Summe aus m plus n nicht größer als fünf ist. Halogen ist Chlor oder Brom, vorzugsweise jedoch Fluor.

Beispiele für $C_1$-$C_8$-Alkyl sind teilweise oder völlig halogeniertes, vorzugsweise fluoriertes Methyl, Äthyl, die verschiedenen Propyl- und Butyl-Gruppen, Pentyl, Hexyl, Octyl und Decyl, vorzugsweise Methyl, Äthyl und Propyl, insbesondere Äthyl und Propyl.

Die zur Herstellung der Polymerisate gemäß der Erfindung eingesetzten Styrole und deren Herstellung sind in der am selben Tag eingereichten deutschen Patentanmeldung (P 38 28 063.9, Titel "Substituierte (2-Haloalkoxy-1,1,2-trifluoräthoxy)styrole, Verfahren zu ihrer Herstellung und ihre Verwendung", auf die hiermit Bezug genommen wird, beschrieben worden.

Ein weiterer Gegenstand der vorliegenden Erfindung ist die Verwendung der oben genannten Polymerisate als Trägermaterialien für die Gelpermeationschromatographie.

Die Herstellung der Homopolymerisate von Styrolen der allgemeinen Formel (I) erfolgt durch radikalische Polymerisation, wobei die radikalische Polymerisation rein thermisch, durch energiereiche Strahlung oder durch wasser-oder öllösliche Radikalbildner (Starter) ausgelöst wird. Wasserlösliche Starter werden bei der Emulsionspolymerisation, öllösliche Starter bei der Masse-, Lösungs- und Suspensionspolymerisation eingesetzt. Wasserlösliche Starter sind beispielsweise die wasserlöslichen Salze, insbesondere Ammonium-, Kalium- und Natriumsalze von Persäuren, wie Peroxymono- und Peroxydischwefelsäure, gegebenenfalls auch der Perphosphorsäure.
Öllösliche Startersysteme sind z.B. Azo-Verbindungen wie Azo-bis-isobutyronitril, ferner sind derartige Azo-Verbindungen beschrieben in US-A 2 471 959; 2 515 628 und 2 520 338; weiterhin finden auch peroxidische Starter wie Hydroperoxide, Peroxide, Perester, Peracetale und ähnliche Verwendung; als Beispiele seien genannt: Dibenzoyl-, Benzoyl-tert.-butyl-, Di-tert.-butylperoxid, Diacetylperoxid. Geeignet sind ferner auch Perhalogenacylperoxide. Im niederen Temperaturbereich können als Starter auch die bekannten Redox-Systeme z.B. Peroxydisulfat/Hydrogensulfit oder Peroxydisulfat/Thiosulfat mit Natrium oder Kalium als Kationenanteil eingesetzt werden. Die zugegebene Menge liegt zwischen 0,0002 und 2 Gew.-%, vorzugsweise zwischen 0,0003 und 1 Gew.-%, bezogen auf die Gesamtmenge der eingesetzten Monomeren. Dabei kann die gesamte Katalysatormenge am Beginn der Reaktion zugegeben werden. Im Falle größerer Ansätze kann es jedoch zweckmäßig sein, die Gesamtmenge des Katalysators kontinuierlich im Verlauf der Polymerisation zuzuschleusen. Die Polymerisationstemperatur richtet sich nach der Zerfallszeit des Starters und beträgt im allgemeinen 20 bis 150 °C, vorzugsweise 50 bis 140 °C.

Erfolgt die Polymerisation in wäßriger Emulsion, so muß dem Polymerisationsansatz mindestens ein Emulgator zugesetzt werden, z.B. teilverseiftes Polyvinylacetat, Polyvinylalkohol, Celluloseether, längerkettige aliphatische Carbon- oder Sulfonsäuren mit mehr als 6 C-Atomen in der Kette und ähnliche.

Für den Fall, daß in Gegenwart von Lösungsmitteln gearbeitet wird, werden oft halogenhaltige Lösungsmittel verwendet wie Benzotrifluorid; weiterhin sind perhalogenierte Chlor und/oder Fluor enthaltene Lösungsmittel bevorzugt, die mit den Monomeren eine homogene Phase bilden, z.B. Trifluortrichloräthylen.

Die Polymeren können beispielsweie durch Eindampfen der Lösung oder durch Ausfällung aus dem Reaktionsansatz gewonnen werden. Die erhaltenen Polymeren können gegebenenfalls durch Umfällen gereinigt werden.

Erfindungsgemäß können auch Mischpolymerisate von Styrolen der allgemeinen Formel (I) und weiteren polymerisationsfähigen Comonomeren hergestellt werden. Die Mischpolymerisate enthalten dabei 1-95 mol-%, vorzugsweise 5-70 mol-% Styrole der allgemeinen Formel (I), bezogen auf die Gesamtmenge der eingesetzten Monomere.

Als polymerisationsfähige Comonomere seien genannt Styrol, Alkyl-, Alkoxy-, Halogenalkyl-, Halogenalkoxy-styrole jeweils mit 1-8, vorzugsweise 1 bis 4 C-Atomen im Alkyl oder Alkoxyrest, wobei Halogen Fluor oder Chlor darstellt, oder halogensubstituierte Styrole wie Pentafluorstyrol; ferner Acrylate, halogenhaltige Acrylate, Methacrylate, halogenhaltige Methacrylate, jeweils mit 1-3 C-Atomen im Esterrest, (Meth)Acrylnitril, Vinyläther, sowie halogenhaltige $\alpha$-Olefine.

Gegebenenfalls können den Reaktionsansätzen auch bifunktionelle Comonomere hinzugeführt werden, um Vernetzungen zu erzielen, z.B. Divinylbenzol.

Die Herstellung der Mischpolymeriste erfolgt auch hier durch radikalische Polymerisation in Substanz, in Gegenwart von organischen Lösungsmitteln oder in wäßriger Emulsion, wobei die Polymerisation in Gegenwart organischer Lösungsmittel bevorzugt wird. Die Wahl des Lösungsmittels erfolgt derart, daß keine Phasentrennung zwischen den Styrolen der allgemeinen Formel (I) und den Comonomeren erfolgt; bevorzugt werden auch hier halogenhaltige Lösungsmittel wie Benzotrifluorid; gegebenenfalls können auch Lösungsmittelgemische verwendet werden.
Als Radikalbildner finden die oben genannten Verbindungen Verwendung.

Die erhaltenen Polymere weisen interessante Eigenschaften auf; sie besitzen beispielsweise niedere Brechungsindices, niedere Glasübergangstemperaturen und sie lösen sich sowohl in halogenfreien Lösungsmitteln wie Tetrahydrofuran als auch in halogenhaltigen Lösungsmitteln z.B.

$HCF_2-(CF_2)_2-O-CF(CF_3)-CF_2-O-CFBr-CF_2Br$

(Hal LM I); derartige Lösungsmittel sind in EP-A 0 260 587 beschrieben.

Aufgrund ihrer Eigenschaften finden die Polymere Verwendung: für optische Systeme, als Schichten für lichtempfindliche photographische Materialien, als Trägermaterialien für chromatographische Trennprozesse, als Gummi, als Formteile, als wasser- und schmutzabweisende Schichten, als Filmmaterial zur Gasseparierung und für Resists, als Antifäulnisanstrich, als Hilfsstoffe für die Papier- und Textilbehandlung und als Kleber. Mit oben genannten Polymeren lassen sich ferner festhaftende Filme auf fluorhaltigen Polymeren herstellen; sie dienen außerdem zur Herstellung von Lichtleitern bzw. für deren Beschichtung.

Besondere Verwendung finden die Polymere gemäß der Erfindung bei der Herstellung von Trennphasen und Trägermaterialien für chromatographische Trennprozesse, insbesondere für die Gelpermeationschromatographie oder Flüssigphasenchromatographie.

## Beispiele

1) Ein Gemisch aus 1,5 g 4-[2-(Hexafluorpropoxy)-1,1,2-trifluoräthoxy]-styrol und 10 mg Azo-bis-isobutyronitril (AIBN) wurden sorgfältig von Sauerstoff befreit und bei 75 °C 24 Stunden polymerisiert (Substanzpolymerisation). Das Polymere wurde in nahezu quantitativer Ausbeute als glasklare Masse erhalten. Zur Entfernung von Monomerspuren wurde es bei 50 °C/0,01 Torr für 24 Stunden getrocknet.
Die GPC-Analyse in Tetrahydrofuran (THF) als Lösungsmittel ergab ein Molekulargewicht von 100000
Tg = 20 ± 5 °C, $n_D$ = 1,425

2) 1,5 g 4-[2-(Hexafluorpropoxy)-1,1,2-trifluoräthoxy]-styrol wurden mit 15 mg Di-tert-butylperoxid in einer wäßrigen Flotte (bestehend aus 100 ml Wasser, 100 mg Perfluoroctansäure-Ammoniumsalz) bei 100 °C 20 Stunden polymerisiert (Emulsionspolymerisation).
Ausbeute: 1,2 g Polymerisat mit einem Molekulargewicht von 120000.
$T_g$ = 20 ± 5 °C, $n_D$ = 1,425

3) 2 g 4-[2-(Pentafluoräthoxy)-1,1,2-trifluoräthoxy]-styrol wurden mit 10 mg AIBN analog Beispiel 1 polymerisiert.
Molekulargewicht 100 000, Ausbeute 1,8 g
$T_g$ = 30 ± 5 °C, nD = 1,426

4) 5 g 4-[2-(Heptafluorpropoxy)-1,1,2-trifluoräthoxy]-styrol (F-Monomer) wurden mit 50 mg AIBN bei 70 °C 48 Stunden polymerisiert. Nach dem Entfernen des restlichen Monomeren verblieben 4,2 g Polymerisat.
Molekulargewicht: 40000
$T_g$ = 20 ± 5 °C, $n_D$ = 1,420

5) 1,5 g 4-[2-(2-Heptafluorpropoxy-hexafluorpropoxy)-1,1,2-trifluoräthoxy]-styrol wurden mit 10 mg AIBN bei 80 °C 24 Stunden polymerisiert. Nach dem Entfernen des restlichen Monomeren verblieben 1,2 g Polymerisat, löslich in Hal LM I.
$T_g$ = 15 ± 5 °C, $n_D$ = 1,375

6) 2 g 2,3,4-Tris-[2-(Heptafluorpropoxy)-1,1,2-trifluorethoxy]-styrol wurden bei 140 °C 20 Stunden thermisch polymerisiert. Der Reaktionsrückstand wurde mit $CH_2Cl_2$ gewaschen. Nach dem Trocknen wurden 1,3 g Polymerisat erhalten, löslich in Hal LM I.
$T_g$ = 30 ± 5 °C, $n_D$ = 1,370

7) 0,5018 g F-Monomer, 1,5016 g Styrol und 0,0104 g AIBN wurden in 3 ml Benzotrifluorid gelöst und für 24 Stunden bei 70 °C polymerisiert. Das Copolymere wird mit Methanol ausgefällt. Man erhält einen weißen, feinkörnigen Niederschlag in einer Menge von 1,29 g.
Die GPC-Analye in THF als Lösungsmittel ergab ein Molekulargewicht von 45000.
Die Elementaranalyse zeigte folgende Werte: C 63,2, H 5,2, F 13,7.
Dies entspricht einem Monomerverhätnis Styrol/F-Monomer von 9,6:1.
$T_g$: 87 ± 3 °C, $n_D$: 1,535

8) 1,0051 g F-Monomer, 1,0409 g Styrol und 0,01 g AIBN wurden in 3 ml Benzotrifluorid gelöst und für 24 Stunden bei 70 °C polymerisiert. Das Polymere wurde mit Methanol ausgefällt und dabei 1,35 g Produkt erhalten. Die Elementaranalyse ergab folgende Werte: C 64,89, H 4,74, F 26,0. Dies entspricht einem F-Monomeranteil von 53 Gew-%. Das Monomerverhältnis Styrol/F-Monomer im Polymeren beträgt 3,3:1. Die GPC-Analyse in THF als Lösungsmittel ergab ein Molekulargewicht von 52000. Das Polymer löste sich ebenfalls bei Temperaturen oberhalb 60 °C in Hal LM I.
$T_g$ = 55 ± 3 °C, $n_D$ = 1,510

9) 0,9998 g F-Monomer, 1,0066 g Pentafluorstyrol und 0,0102 g AIBN wurden in 3 ml Benzotrifluorid gelöst und für 72 Stunden auf 70 °C gehalten. Die leicht viskose, klare Lösung wurde in Methanol ausgefällt, wobei 1,68 g eines farblosen Polymeren erhalten wurden.
Aus den 19 F-NMR-Spektren ergab sich ein Monomerverhältnis Pentafluorstyrol/F-Monomer von 1,8:1
Molekulargewicht: 45000
$T_g = 30 \pm 5$ °C, $n_D = 1{,}440$
Das Polymere ist löslich in THF und Hal LM I.

10) Beispiel 9 wurde mit 0,5029 g F-Monomer, 1,5054 g Pentafluorstyrol und 0,01 g AIBN wiederholt. Es wurden 1,77 g des festen weißen Polymeren erhalten, löslich in Hal LM I oberhalb 60 °C.
Monomerverhältnis: Pentafluorstyrol/F-Monomer = 4,2:1
Molekulargewicht 50000
$T_g = 78 \pm 3$ °C, $n_D = 1{,}459$

## Ansprüche

1. Homo- und Copolymerisate auf Basis von (2-Halo-alkoxy-1,1,2-trifluoräthoxy)-styrolen der allgemeinen Formel

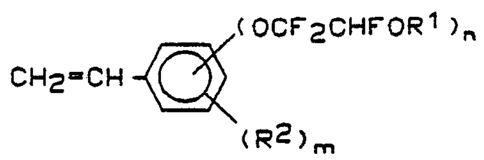

(I)

worin
$R^1$ teilweise oder vollständig halogeniertes $C_1$-$C_{10}$ Alkyl oder einen Rest der Formel

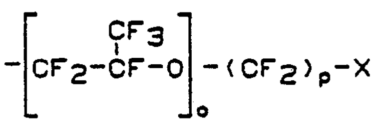

(II)

oder

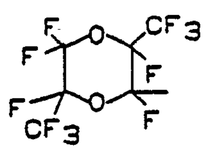

(III)

und $R^2$, Wasserstoff, Halogen oder eine teilweise oder vollständig halogeniertes $C_1$-$C_8$ Alkyl-Gruppe, wobei die Alkylgruppen $R^1$ und $R^2$ gleich oder verschieden sind,
m ist als ganze Zahl 1, 2, 3 oder 4,
n ist als ganze Zahl 1, 2 oder 3,
ist als ganze Zahl 1, 2, 3 oder 4,
p ist als ganze Zahl 1, 2, 3, 4, 5, 6, 7, 8, 9 oder 10 und X Wasserstoff oder Halogen bedeutet, mit der Maßgabe, daß die Summe aus m plus n nicht größer als fünf ist.

2. Polymerisate nach Anspruch 1, dadurch gekennzeichnet, daß Halogen Chlor oder Brom, vorzugsweise Fluor ist.

3. Verfahren zur Herstellung von Homo- oder Copolymerisaten auf Basis von Styrolen der allgemeinen Formel (I), dadurch gekennzeichnet, daß die Styrole, gegebenenfalls zusammen mit copolymerisierbaren Monomeren, durch radikalische Polymerisation in Gegenwart von Radikalbildnern umgesetzt werden.

4. Verfahren nach Anspruch 3, dadurch gekennzeichnet, daß die Polymerisation als Emulsions-, Masse-, Lösungs- oder Suspensionspolymerisation durchgeführt wird.

5. Verfahren nach Anspruch 3 oder 4, dadurch gekennzeichnet, daß die Menge an eingesetzten Radikalbildnern 0,0002 bis 2, vorzugsweise 0,0003 bis 1 Gew.-%, bezogen auf die Gesamtmenge der eingesetzten Monomeren, beträgt.

6. Verfahren nach einem oder mehreren der Ansprüche 3 bis 5, dadurch gekennzeichnet, daß die Polymerisationstemperatur 20 bis 150, vorzugsweise 50 bis 140 °C beträgt.

7. Verfahren nach einem oder mehreren der Ansprüche 3 bis 6, dadurch gekennzeichnet, daß bei der Emulsionspolymerisation mindestens ein Emulgator zugesetzt wird.

8. Ausführungsform nach einem oder mehreren der Ansprüche 1 bis 7, dadurch gekennzeichnet, daß die Copolymerisate 1 bis 95 mol-%, vorzugsweise 5 bis 70 mol-% Styrole der Formel (I) enthalten, bezogen auf die Gesamtmenge der eingesetzten Monomere.

9. Ausführungsform nach einem oder mehreren der Ansprüche 1 bis 8, dadurch gekennzeichnet, daß die Copolymere bifunktionelle Comonomere enthalten.

10. Ausführungsform nach einem oder mehreren der Ansprüche 1 bis 9, dadurch gekennzeichnet, daß als Comonomere Styrol, Alkyl-, Alkoxy-, Halogenalkyl-, Halogenalkoxy-styrole, jeweils mit 1-8, vorzugsweise 1-4 C-Atomen im Alkyl- oder Alkoxyrest, wobei Halogen Fluor oder Chlor darstellt, oder halogensubstituierte Styrole, Acrylate oder Methacrylate, jeweils mit 1-3 C-Atomen im Esterrest sowie halogenhaltige Verbindungen dieser Acrylverbindungen, Acryl- und Methacrylnitril; Vinyläther oder halogenhaltige $\alpha$-Olefine eingesetzt werden.

11. Verwendung der Polymerisate nach Anspruch 1 als Trägermaterial und Trennphasen für chromatographische Verfahren, als Material für optische Systeme, als Resists, als Formteile und Klebstoffe.

12. Verwendung nach Anspruch 11 in Form von Lichtleiter oder als Beschichtungsmaterial dafür, ferner als Trägermaterial und Trennphasen für die Gelpermeations- und Flüssigphasenchromatographie.